# EUROPÄISCHE PATENTANMELDUNG

(11) **EP 0 822 496 A2**
(43) Veröffentlichungstag der Anmeldung: **04.02.1998**
(21) Anmeldenummer: 97112170.2
(22) Anmeldetag: 16.07.1997
(51) Int. Cl.: G06F 11/20

(54) **Fuse-Refresh-Schaltung**

(30) Priorität: 01.08.1996 DE 19631130
(71) Anmelder: SIEMENS AKTIENGESELLSCHAFT, 80333 München (DE)
(72) Erfinder: Savignac, Dominique, Dr.-rer.nat., 85737 Ismaning (DE); Brede, Rüdiger, Dipl.-Phys., 85635 Höhenkirchen (DE); Wirth, Norbert, Dipl.-Phys., 85716 Unterschleissheim (DE)

(57) **Zusammenfassung**

Die Erfindung betrifft eine Fuse-Refresh-Schaltung für Halbleiter-Speicheranordnungen, bei der nach Einschalten einer Spannungsversorgung eine Fuse-Latch-Schaltung (17, 19, 50, 56) in mindestens einem Refresh-Zyklus von einer Setzschaltung gesetzt wird. Während des Refresh-Zyklus der Fuse-Latch-Schaltung (17, 19, 50, 56) wird diese mit Impulsen (CLRNX, SETPX, SETPSP) derart angesteuert, daß der Zustand der Fuse-Latch-Schaltung (17, 19, 50, 56) ausgewertet und nur eine falsch gesetzte Fuse-Latch-Schaltung richtig gesetzt wird.

## Beschreibung

Die vorliegende Erfindung bezieht sich auf eine Fuse-Refresh-Schaltung nach dem Oberbegriff des Patentanspruchs 1.

Fuse-Refresh-Schaltungen werden bekanntlich zur Gewährleistung der Redundanz speziell in Halbleiter-Speicheranordnungen eingesetzt. Nach dem Redundanz-Prinzip müssen nämlich in einer Halbleiter-Speicheranordnung gegebenenfalls fehlerhafte Speicherzellen durch einwandfrei arbeitende Speicherzellen ersetzt werden. Die Fuse-Refresh-Schaltung stellt dabei eine Einrichtung dar, die abhängig von den ihr zugeführten logischen Signalen an ihrem Ausgang einen definierten logischen Zustand liefert, der eine "0" oder "1" sein kann, was wiederum davon abhängt, ob die Fuse durchtrennt ist oder nicht. Die deutsche Bezeichnung "Sicherung" ist für "Fuse" also insoweit zutreffend, als eine elektrische Leitung eingeschaltet bzw. gesetzt oder durchtrennt ist. Unter "Refresh" ist zu verstehen, daß die einzelnen Fuses bei Einschalten der Halbleiter-Speicheranordnung mittels Fuse-Latch-Schaltungen überprüft, also insoweit "aufgefrischt" werden.

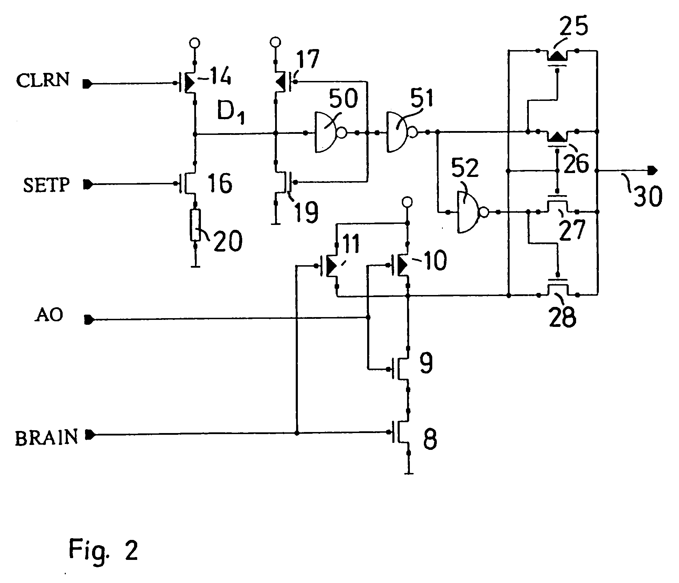

Dies soll im folgenden anhand der Fig. 2 näher erläutert werden, die eine herkömmliche Fuse-Refresh-Schaltung zeigt.

Nach dem Einschalten eines beispielsweise 16 Mbit DRAM liefert eine in der Fig. 2 nicht gezeigte Setzschaltung für ein Signal CLRN eine Spannung, die bei einer Betriebsspannung von etwa 1 V einen Wert von 0 V hat. Erreicht anschließend die Betriebsspannung sodann einen Wert von etwa 2,7 V, so nimmt das Signal CLRN ebenfalls einen Wert von 2,7 V an und folgt sodann im weiteren Verlauf der Betriebsspannung. Das Signal CLRN wird einem p-MOS-Transistor bzw. FET 14 der Fuse-Refresh-Schaltung zugeführt. Dieser p-MOS-Transistor 14, der eine negative Einsatzspannung hat, liegt in Reihe zu einem n-MOS-Transistor 16, der eine positive Einsatzspannung hat, und zu einer Fuse 20. Dieser Reihenschaltung ist eine Fuse-Latch-Schaltung aus Transistoren 17, 19 des zueinander entgegengesetzten Leitfähigkeitstyps und einem Inverter 50 nachgeschaltet.

Durch das Signal CLRN wird, bevor es die Betriebsspannung V_{B} erreicht hat (vergleiche Fig. 2a), über den p-MOS-Transistor 14 die Fuse-Latch-Schaltung so gesetzt, daß an ihrem Eingang D1 eine "1" liegt, d.h., es gilt D1 = "1".

Nachdem das Signal CLRN auf die Betriebsspannung gegangen ist, liefert die (nicht gezeigte) Setzschaltung für ein Signal SETP, das Gate des MOS-Transistors 16 zugeführt ist, einen Spannungspuls mit einer Dauer von etwa 20 ns. Ist nun die Fuse 20 durchtrennt, so bleibt der Eingang D1 auf "1" gesetzt. Ist die Fuse 20 aber nicht getrennt, so wird die Fuse-Latch-Schaltung so gesetzt, daß D1 = "0" gilt. Abhängig von dem Zustand von D1, einem Adress-Signal AO und einem Brain-Signal BRAIN liegt dann am Ausgang 30 der Fuse-Refresh-Schaltung eine "0" oder eine "1".

Zwischen dem Inverter 50 und dem Ausgang 30 ist eine zweistufige Inverterschaltung aus Invertern 51, 52 und eine Parallelschaltung aus MOS-Transistoren 25, 26, 27 und 28 vorgesehen, wobei die MOS-Transistoren 25, 26 den gleichen Leitfähigkeitstyp wie der MOS-Transistor 14 bzw. 17 haben und die MOS-Transistoren 27, 28 den gleichen Leitfähigkeitstyp wie der MOS-Transistor 16 bzw. 19 aufweisen. Gate des MOS-Transistors 25 ist dabei mit Source bzw. Drain des MOS-Transistors 26 verbunden, dessen Gate an Gate des MOS-Transistors 27 angeschlossen ist. Source bzw. Drain des Transistors 27 ist wiederum mit Gate des MOS-Transistors 28 verbunden. Source bzw. Drain des MOS-Transistors 28 ist mit den Sources bzw. Drains von MOS-Transistoren 10, 11 verbunden, die vom gleichen Leitfähigkeitstyp wie der MOS-Transistor 14 sind. Gate des MOS-Transistors 10 und Gate eines hierzu in Reihe liegenden MOS-Transistors 9 ist das Adress-Signal AO zugeführt, während an Gate des Transistors 11 und eines MOS-Transistors 8 das Signal BRAIN liegt.

Aus Gründen, die im Einzelfall nur schwer zu klären sind, treten bei der bestehenden Fuse-Refresh-Schaltung von Fig. 2 Probleme wegen falsch gesetzten Fuse-Latch-Schaltungen auf. Mit anderen Worten, das Signal D1 hat bei falsch gesetzter Fuse-Latch-Schaltung beispielsweise den Wert "1", obwohl es den Wert "0" haben sollte. Als Folge hiervon liegt dann am Ausgang 30 ebenfalls der zum "richtigen Zustand" umgekehrte Zustand vor.

Als mögliche Ursachen für solche falsch gesetzte Fuse-Latch-Schaltungen kann ein partieller Spannungseinbruch auf etwa 1 V beim Einschalten mit sehr steilen Spannungsflanken oder eine nicht vollständig durchtrennte Fuse mit einem Restwiderstand beispielsweise 100 kΩ angenommen werden.

Da ein 16 Mbit DRAM etwa 2000 Fuses besitzt, zieht das Auftreten einer falsch gesetzten Fuse-Latch-Schaltung umfangreiche Untersuchungen nach sich, die dennoch nicht immer eine absolute Klarheit über den aufgetretenen Fehlermechanismus mit sich bringen. Diese Untersuchungen können so umfangreich sein, daß es oft zweckmäßiger ist, die Halbleiter-Speicheranordnung zu verwerfen und nicht nach einer Abhilfe für die falsch gesetzte Fuse-Refresh-Schaltung zu suchen. Selbstverständlich ist ein derartiges Vorgehen aber in jeder Weise unerwünscht.

Es ist daher **Aufgabe** der vorliegenden Erfindung, eine Fuse-Refresh-Schaltung anzugeben, die derart aufgebaut ist, daß ein falscher Setzzustand ohne weiteres zu berichtigen ist.

Diese Aufgabe wird bei einer Fuse-Refresh-Schaltung nach dem Oberbegriff des Patentanspruches 1 erfindungsgemäß durch die in dessen kennzeichnenden Teil enthaltenen Merkmale gelöst. Vorteilhafte Weiterbildungen der Erfindung ergeben sich insbesondere aus den Unteransprüchen.

Wesentlich an der erfindungsgemäßen Fuse-Refresh-Schaltung ist also, daß nur ein falsch gesetzter Zustand berichtigt wird und nicht in jedem Fall ein neues Setzen erfolgt. Mit anderen Worten, in einer Halbleiter-Speicheranordnung werden nur die falsch gesetzten Fuse-Latch-Schaltungen neu gesetzt, während die richtig gesetzten Fuse-Latch-Schaltung beim Refresh-Zyklus nicht neu gesetzt zu werden brauchen. Offenbar kann dadurch auch Strom eingespart werden.

Bei der erfindungsgemäßen Fuse-Refresh-Schaltung werden dieser speziell gestaltete Impulse zugeführt, die letztlich durch Verzögern und Invertieren der Impulse CLRN bzw. SETP erhalten sind, wie dies weiter unten näher erläutert werden wird. Außerdem ist die Reihenschaltung der beiden MOS-Tran-sistoren der Fuse-Latch-Schaltung in vollkommen neuer Weise durch einen zusätzlichen MOS-Transistor erweitert, wodurch es ermöglicht wird, den Setzzustand der Fuse-Latch-Schaltung zu berichtigen.

Nachfolgend wird die Erfindung anhand der Zeichnung näher erläutert. Es zeigen:
- Fig. 1: eine Fuse-Setz-Schaltung;
- Fig. 2: eine herkömmliche Fuse-Refresh-Schaltung;
- Fig. 2a: einen Signalverlauf hierzu;
- Fig. 3: die erfindungsgemäße Fuse-Refresh-Schaltung;
- Fig. 4: den Verlauf einzelner Fuse-Refresh-Signale und
- Fig. 5: eine Draufsicht auf die Fuse-Refresh-Schaltungen in einem 16 Mbit DRAM.

Fig. 2 ist bereits eingangs erläutert worden. In der Fig. 2 verwendete Bezugszeichen, die gleiche Teile angeben, werden auch in den folgenden Figuren eingesetzt.

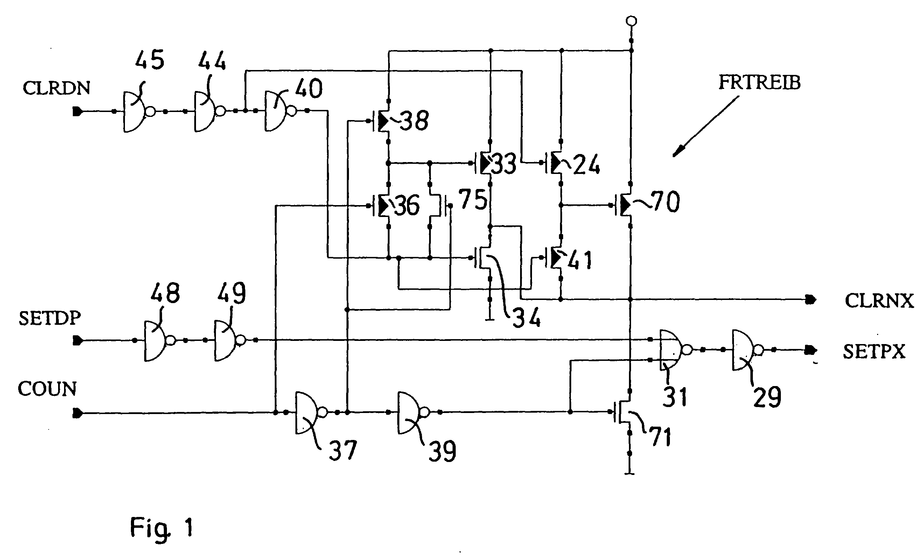

Fig. 1 zeigt eine Fuse-Setz-Schaltung FRTREIB. Diese Schaltung liefert spezielle Signale bzw. Impulse CLRNX und SETPX, die sodann der erfindungsgemäßen Fuse-Refresh-Schaltung anstelle der Signale CLRN und SETP der herkömmlichen Fuse-Refresh-Schaltung von Fig. 2 zugeführt sind.

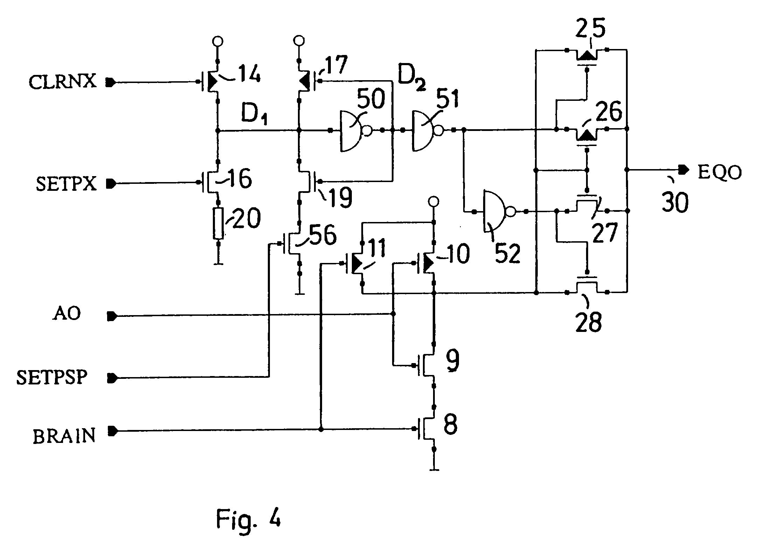

Eingangssignale CLRDN und SETDP der Fuse-Setz-Schaltung von Fig. 1 sind die verzögerten Signale CLRN und SETP der Setzschaltung und werden durch die Fuse-Setz-Schaltung im Prinzip aktiv auf die Signale CLRNX und SETPX durchgeschaltet, deren Verlauf weiter unten anhand der Fig. 4 naher erläutert werden wird. Mittels der Signal CLRNX und SETPX wird sodann die Fuse-Latch-Schaltung der erfindungsgemäßen Fuse-Refresh-Schaltung in ähnlicher Weise gesetzt, wie dies oben anhand der Fig. 2 für die bestehende Fuse-Refresh-Schaltung erläutert wurde.

Wesentlich ist, daß die Signale CLRNX und SETPX etwa den weiter unten anhand der Fig. 4 erläuterten Verlauf haben. Fig. 1 stellt lediglich ein Beispiel dar, wie diese Signale CLRNX und SETPX aus den Signalen COUN, CLRDN und SETDP gewonnen werden können. Selbstverständlich sind auch andere Schaltungsanordnungen möglich, um die Signale CLRNX und SETPX mit dem gewünschten Verlauf aus den Signalen CLRDN und SETDP zu erzeugen.

Im einzelnen wird in der Fuse-Setz-Schaltung von Fig. 1 das Signal CLRDN zunächst einer Reihenschaltung aus drei Invertern 45, 44 und 40 zugeführt. Der Ausgang des Inverters 40 liegt an Gate eines MOS-Transistors 34, der in Reihe zu einem MOS-Transistor 33 geschaltet ist. Außerdem ist der Verbindungspunkt zwischen den Invertern 44 und 40 mit Gate eines MOS-Transistors 24 verbunden, der wiederum in Reihe zu einem MOS-Transistor 41 vorgesehen ist. An Gate des MOS-Transistors 41 und Gate des MOS-Transistors 34 liegt das Ausgangssignal des Inverters 40, das auch über einen MOS-Transistor 75 Gate des MOS-Transistors 33 zugeführt ist. Der Verbindungspunkt zwischen den MOS-Transistoren 24 und 41 ist mit Gate eines MOS-Transistors 70 verbunden. Dieser MOS-Transistor 70 ist wiederum in Reihe zu einem MOS-Transistor 71 vorgesehen, dessen Gate über Inverter 37, 39 mit einem Zählimpuls COUN beaufschlagt ist. Der Impuls SETDP ist über Inverter 48, 49 einem NOR-Gatter 31 zugeführt, dessen anderer Eingang mit Gate des MOS-Transistors 71 bzw. dem Ausgang des Inverters 39 verbunden ist. Am Ausgang des NOR-Gatters 31 ist ein Inverter 29 vorgesehen, der wiederum den Impuls SETPX liefert. Der Zählimpuls COUN ist außerdem Gate eines MOS-Transistors 36 zugeführt, der in Reihe zu einem MOS-Transistor 38 liegt. Mit Gate des MOS-Transistors 38 ist der Ausgang des Inverters 37 verbunden. Source bzw. Drain des MOS-Transistors 38 sind mit Source bzw. Drain der Transistoren 33, 24 und 70 verbunden, wahrend Source bzw. Drain des MOS-Transistors 36 an Source bzw. Drain des MOS-Transistors 75 und Gate des MOS-Transistors 34 liegen.

Die MOS-Transistoren 36, 38, 33, 24, 41 und 70 sind von einem Leitfähigkeitstyp, während die MOS-Transistoren 75, 34 und 71 vom anderen, entgegengesetzten Leitfähigkeitstyp sind.

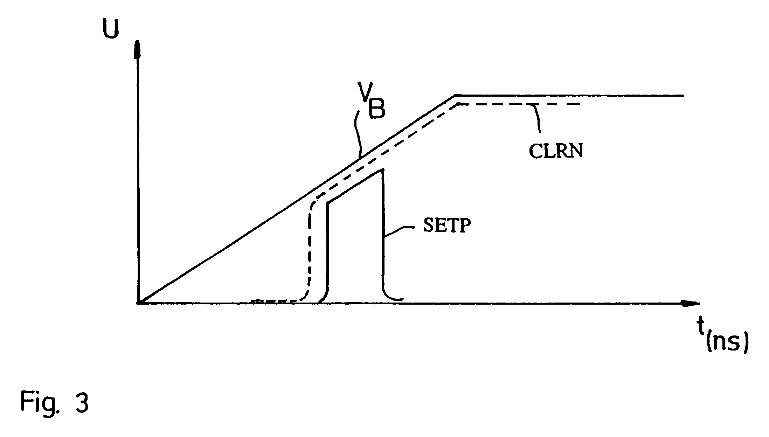

Der FRTREIB-Schaltung von Fig. 1, die - wie bereits erwähnt - abgewandelt werden kann, wobei lediglich wesentlich ist, daß die Signale CLRNX und SETPX mit dem angegebenen Verlauf (vergleiche weiter unten im Zusammenhang mit Fig. 4) erhalten werden, ist die erfindungsgemäße Fuse-Refresh-Schaltung nachgeschaltet, deren Aufbau schematisch in Fig. 3 gezeigt ist.

Die Schaltung von Fig. 3 unterscheidet sich von der Schaltung von Fig. 1 dadurch, daß zusätzlich ein MOS-Transistor 56, der den gleichen Leitfähigkeitstyp wie der MOS-Transistor 19 hat, in Reihe zu diesem MOS-Transistor 19 vorgesehen ist. An Gate dieses MOS-Transistors 56 liegt ein Impuls SETPSP.

Im Betrieb wird die Fuse-Latch-Schaltung aus den MOS-Transistoren 17, 19, 56 und dem Inverter 50, also das Signal D1, nach dem Einschalten der Halbleiter-Speicheranordnung zunächst in gleicher Weise gesetzt, wie dies anhand der Fig. 2 oben erläutert wurde. Sodann werden während der ersten acht RAS-Zyklen, die z.B. laut Spezifikation nach dem Einschalten des 16 Mbit DRAMs vorgeschrieben sind, bevor ein einwandfreies Funktionieren des Bausteins garantiert wird, und in deren Flanken die Zeilen-Adressen (Row-Addresses) eingegeben bzw. "eingelatcht" werden, zwei Fuse-Refresh-Impulse für das Signal COUN (vergleiche Fig. 1) erzeugt. Wie nun aus Fig. 4 ersichtlich ist, erzeugt der Puls COUN durch Verzögerung einen SETPX-Puls, der die Fuse-Latch-Schaltung, die irrtümlich auf beispielsweise "1" gesetzt war, auf "0" setzt (vergleiche den Impuls D1 (FUSEX)). Gleichzeitig wird das der Fuse-Refresh-Schaltung von Fig. 3 zugeführte Signal CLRNX um eine definierte, durch den Transistor 71 (vergleiche Fig. 1) einstellbare Spannung abgesenkt. Dadurch wird der Transistor 14 (vergleiche Fig. 3) etwas leitend gemacht, so daß ein Spannungsteiler aus den Transistoren 14, 16 und dem Widerstand der Fuse 20 gebildet wird. Ist nun der Widerstand der Fuse 20 größer als etwa 50 kΩ, d.h. ist die Fuse getrennt, so ist der Spannungsteiler aus den MOS-Transistoren 14, 16 und der Fuse 20 so eingestellt, daß die Fuse-Latch-Schaltung, die fehlerhaft auf "0" gesetzt war, auf "1" gesetzt wird (vergleiche das Signal D1 (FUSEY)). Dies ist darauf zurückzuführen, daß beispielsweise bei einem Fuse-Widerstand von 100 kΩ und einem Widerstandswert des MOS-Transistors 14 von etwa 50 kΩ sowie einem Widerstandswert des MOS-Transistors 16 von 5 kΩ das Signal D1 auf etwa 2,5 V geht, was den Inverter 50 umkippen läßt, so daß D2 = 0 am Ausgang des Inverters 50 vorliegt, wodurch der Transistor 17 aufgesteuert wird. Damit bekommt der Knoten zwischen den Transistoren 14 und 16 die volle Betriebsspannung von etwa 3,5 V, so daß das Signal D1 richtig auf den Wert "1" gesetzt wird.

Das Signal SETPSP, das Gate des MOS-Transistors 56 zugeführt ist, wird durch eine dreistufige Inverterkette aus dem Signal SETPX erzeugt und schaltet den Transistor 56 ab. Dieses Abschalten ist erforderlich, da sonst das obige Spannungsteilerprinzip nicht in der gewünschten Weise arbeiten würde. Für einen Zustand D1 = 0 würde ein Zustand D2 = 1 gelten, und bei leitendem Transistor 19 wäre die Fuse 20 kurzgeschlossen. Ist die Fuse 20 aber nicht getrennt und das Signal D1 zurecht auf "0" gesetzt, so bleibt das Signal D1 auf 0 gesetzt, da im obigen Spannungsteiler der Widerstand der Fuse 20 klein ist, was auch für den Spannungsabfall gilt.

Durch die Vergrößerung der Weite des Transistors 71 (vergleiche Fig. 1) kann erreicht werden, daß Fuses, deren Widerstandswert kleiner als 50 kΩ ist, also beispielsweise 30kΩ beträgt, beim Fuse-Refresh-Betrieb noch als getrennt erkannt werden können. Ein stärkeres Absinken des Impulses CLRNX wurde allerdings den Stromverbrauch ansteigen lassen.

In der Fig. 4 ist der Zusammenhang der Signal COUN, SETPX, SETPSP, CLRNX und D1 (FUSEX) sowie D1 (FUSEY) gezeigt, wobei auf der Abszisse die Zeit t nach dem Einschalten der Halbleiter-Speicheranordnung in ns und auf der Ordinate die Spannung in mV aufgetragen sind.

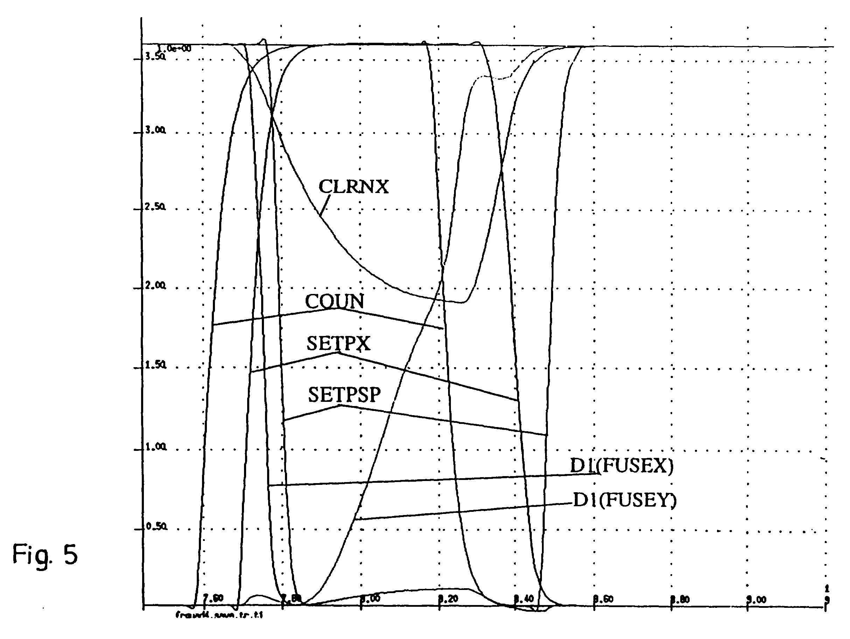

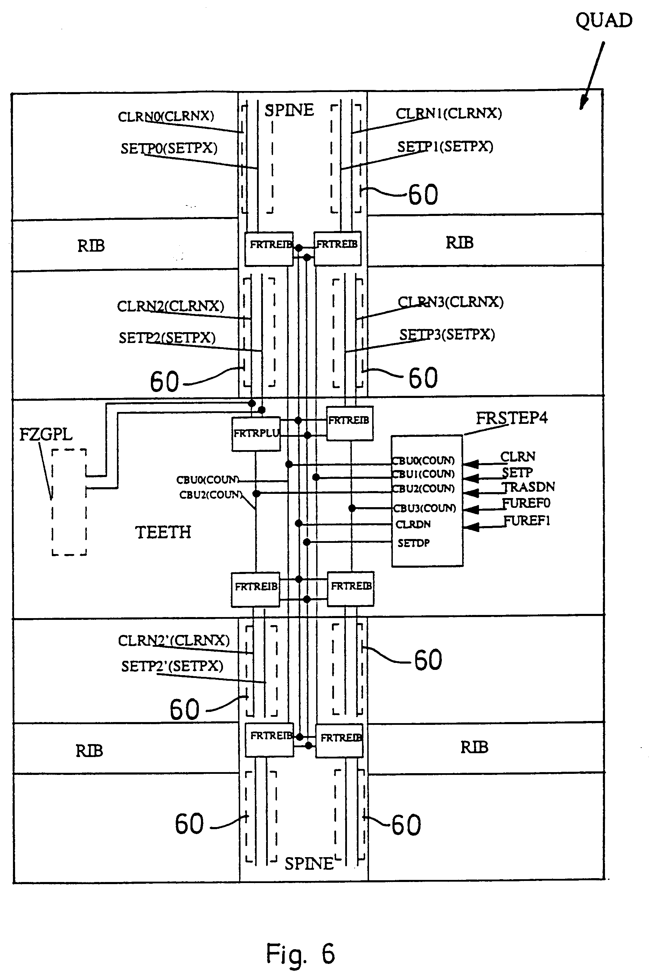

Fig. 5 zeigt eine Draufsicht auf einen 16 Mbit DRAM, wobei angegeben ist, wo auf dieser Halbleiter-Speicheranordnung die Fuse-Setz-Schaltungen FRTREIB und Fuse-Refresh-Schaltungen 60 vorzusehen sind.

Die Erzeugung der Zähl- bzw. Fuse-Refresh-Auslöseimpulse COUN wird durch die Schaltung FRSTEP4 vorgenommen, die mit dem Busbereich der Halbleiter-Speicheranordnung verbunden ist. Während der ersten acht RAS-Zyklen nach dem Einschalten der HalbleiterSpeicheranordnung liefert diese Schaltung FRSTEP4 für jeden RAS-Zyklus jeweils einen Fuse-Refresh-Puls, d.h. eines der schematisch angegebenen vier Signal CBU0, CBU1, CBU2 und CBU3, die aus dem Zählimpuls COUN gewonnen sind, liefert einen Fuse-Refresh-Puls. Damit nämlich der Fuse-Refresh-Betrieb möglichst wenig Strom verbraucht, werden bei dem 16 Mbit DRAM jeweils nur ein Viertel der Fuse "refreshed". Das COUN-Signal für das erste Viertel des Bausteins heißt CBU0, für das zweite Viertel CBU1, usw. Während der ersten acht RAS-Zyklen werden also pro RAS-Zyklus die Fuse-Refresh-Schaltungen 60 eines Quadranten QUAD "aufgefrischt" bzw. "refreshed", nämlich beispielsweise ein halber Quadrant QUAD oberhalb des Bereiches TEETH und ein halber Quadrant unterhalb des Bereiches TEETH.

Auch eine Schaltung FZGPL im TEETH-Bereich wird wahrend des Signales CBU0 mit einem Fuse-Refresh-Impuls beaufschlagt.

Spätestens nach den ersten achten RAS-Zyklen nach jedem Einschalten der Halbleiter-Speicheranordnung sollten alle Fuse-Latch-Schaltungen richtig gesetzt sein. Um nun den Stromverbrauch durch den Fuse-Refresh-Betrieb niedrig zu halten, liefert die FRSTP4-Schaltung nach den ersten acht RAS-Zyklen nur noch einen Fuse-Refresh-Puls für je zweiunddreißig RAS-Zyklen bzw. einen Fuse-Refresh-Impuls für je sechzehn oder acht oder vier RAS-Zyklen, was über zwei Fuse-Polysilizium-Brücken FZSTR4, FZSTR5 (nicht gezeigt) programmierbar ist.

Die Fuse-Refresh-Häufigkeit kann der folgenden Tabelle 1 entnommen werden:

**Tabelle 1**

| Fuse-Refresh-Häufigkeit | | |
|---|---|---|
| FZSTR4-Fuse | FZSTR5-Fuse | Fuse-Refresh-Häufigkeit |
| nicht getrennt | nicht getrennt | 1 Fuse-Refresh-Puls für je 32 RAS-Zyklen. Eine bestimmte Redundanz-Fuse wird also innerhalb von 128 RAS-Zyklen einmal refreshed. |
| | | Default-Einstellung |
| getrennt | nicht getrennt | 1 Fuse-Refresh-Puls für je 16 RAS-Zyklen |
| nicht getrennt | getrennt | 1 Fuse-Refresh-Puls für je 8 RAS-Zyklen |
| getrennt | getrennt | 1 Fuse-Refresh-Puls für je 4 RAS-Zyklen. Eine bestimmte Redundanz-Fuse wird also innerhalb von 16 RAS-Zyklen einmal refreshed. |

Zur Unterscheidung zwischen den einzelnen Quadranten sind in der Fig. 5 die den Signalen zugeordneten Busse, die vor allem in Bereichen SPINE und RIB gelegen sind, mit einem Zahlenzusatz versehen. So ist beispielsweise der zur Fuse-Refresh-Schaltung 60 rechts oben geführte Bus für das Signal CLRN bzw. CLRNX durch "CLRN1" bezeichnet. Ähnliches gilt für die Busse für das Signal "SETP1".

Der Fuse-Refresh-Puls wird etwa 7 ns erzeugt, nachdem ein TRASP-Signal von "1" auf "0" gegangen ist. Selbstverständlich ist hier aber auch eine andere Zeitsteuerung möglich.

Die erfindungsgemäße Fuse-Refresh-Schaltung, bei der richtig gesetzte Fuse-Latch-Schaltungen nicht neu gesetzt werden und die sich durch einen geringen Stromverbrauch auszeichnet, kann nicht nur bei DRAMs sondern beispielsweise auch bei Festwertspeichern bzw. ROMs eingesetzt werden.

Bei der erfindungsgemäßen Fuse-Refresh-Schaltung werden also dieser speziell geschaltete Signale zugeführt, die aus den Signalen COUN, CLRDN, SETDP in der Schaltung FRTREIB erzeugt werden. Die Signale CLRDN und SETDP sind die verzögerten Signale CLRN bzw. SETP (vergleiche Fig. 2a), die ohne Veränderung von der Schaltung FRTREIB durchgelassen werden und zu den Signalen CLRNX bzw. SETPX werden. Mit diesen Signalen werden die Fuse-Latch-Schaltungen nach Anlegen der Betriebsspannung in üblicher Weise gesetzt. Ein Fuse-Refresh-Betrieb wird anschließend durch das Signal COUN durchgeführt, welches mit Hilfe der Schaltung FRTREIB die speziell geformten Signale CLRNX und SETPX (vergleiche Fig. 4) erzeugt.

## Patentansprüche

1. Fuse-Refresh-Schaltung für Halbleiter-Speicheranordnung, bei der nach Einschalten einer Spannungsversorgung eine Fuse-Latch-Schaltung in mindestens einem Refresh-Zyklus von einer Setzschaltung (Fig. 1) gesetzt wird,
**dadurch gekennzeichnet,**
daß während des Refresh-Zyklus der Fuse-Latch-Schaltung (17, 19, 50, 56) die Setzschaltung (Fig. 1) die Fuse-Latch-Schaltung (17, 19, 50, 56) mit Impulsen (CLRNX, SETPX, SETPSP) ansteuert, derart, daß der Setzzustand der Fuse-Latch-Schaltung (17, 19, 50, 56) ausgewertet und nur eine falsch gesetzte Fuse-Latch-Schaltung neu richtig gesetzt wird.

2. Fuse-Refresh-Schaltung nach Anspruch 1,
**dadurch gekennzeichnet,**
daß die Fuse-Latch-Schaltung (17, 19, 50, 56) drei in Reihe geschaltete MOS-Transistoren (17, 19, 56) und einen Inverter (50) aufweist, von denen der erste MOS-Transistor (17) von einem ersten Leitfähigkeitstyp und der zweite und dritte MOS-Transistor (19, 56) von einem zweiten, zum ersten entgegengesetzten, Leitfähigkeitstyp sind und der Inverter (50) mit seinem Eingang mit dem Verbindungspunkt zwischen dem ersten und dem zweiten MOS-Transistor und mit seinem Ausgang mit den Gates des ersten bzw. zweiten MOS-Transistors verbunden ist, daß das dem zweiten MOS-Transistor (19) abgewandte Ende des dritten MOS-Transistors (36) auf Bezugpotential, insbesondere Masse, liegt, und daß Gate des dritten MOS-Transistors (36) mit einem ersten (SETPSP) der Impulse (CLRNX, SETPX, SETPSP) angesteuert ist.

3. Fuse-Refresh-Schaltung nach Anspruch 1 oder 2,
**dadurch gekennzeichnet**,
daß der Eingang des Inverters (50) mit einer Reihenschaltung aus einem vierten MOS-Transistor (14) des ersten Leitfähigkeitstyp, einem fünften MOS-Transistor (16) des zweiten Leitfähigkeitstyps und einer Fuse (20) verbunden ist.

4. Fuse-Refresh-Schaltung nach Anspruch 3,
**dadurch gekennzeichnet,**
daß ein zweiter und ein dritter der Impulse (CLRNX, SETPX) jeweils den Gates des vierten bzw. fünften MOS-Transistors (14, 16) zugeführt ist.

5. Fuse-Refresh-Schaltung nach Anspruch 4,
**dadurch gekennzeichnet**,
daß der erste Impuls (SETPSP) durch Invertieren und Verzögern des dritten Impulses (SETPX) erzeugt ist.

6. Fuse-Refresh-Schaltung nach einem der Ansprüche 3 bis 5,
**dadurch gekennzeichnet,**
daß der Eingang des Inverters (50) mit dem Verbindungspunkt zwischen dem vierten und fünften MOS-Transistor (14, 16) verbunden ist.

7. Fuse-Refresh-Schaltung nach einem der Ansprüche 3 bis 6,
**dadurch gekennzeichnet,**
daß der zweite Impuls (CLRNX) einen gegenüber dem dritten Impuls (SETPX) abgesenkten Potentialpegel hat.

8. Fuse-Refresh-Schaltung nach einem der Ansprüche 3 bis 7,
**dadurch gekennzeichnet,**
daß der dritte Impuls (SETPX) in der Setzschaltung (Fig. 1) durch eine Reihenschaltung aus Invertern (37, 39, 29) und einem NOR-Gatter (31) während eines RAS-Zyklus aus einem Fuse-Refresh-Auslöseimpuls (COUN) und einem Setzimpuls (SETDP) abgeleitet ist.

9. Fuse-Refresh-Schaltung nach Anspruch 8,
**dadurch gekennzeichnet,**
daß der zweite Impuls (CLRNX) in der Setzschaltung (Fig. 1) durch mehrere Inverter während des RAS-Zyklus aus dem Fuse-Refresh-Auslöseimpuls und einem Clearimpuls (CLRDN) abgeleitet ist.
